# EUROPÄISCHE PATENTSCHRIFT

(11) **EP 3 603 356 B1**
(45) Veröffentlichungstag und Bekanntmachung des Hinweises auf die Patenterteilung: **12.05.2021**
(21) Anmeldenummer: 18711301.4
(22) Anmeldetag: 13.03.2018
(51) Int. Cl.: H05K 3/34, H05K 3/22, H01L 23/00, H01L 21/56, H05K 3/28

(54) **KONTAKTANORDNUNG**
CONTACT ARRANGEMENT
ARRANGEMENT DE CONTACT

(30) Priorität: 22.03.2017 DE 102017204842
(43) Veröffentlichungstag der Anmeldung: 05.02.2020
(73) Patentinhaber: Robert Bosch GmbH, 70442 Stuttgart (DE)
(72) Erfinder: GERA, Guenter, 71229 Leonberg (DE); LEIDICH, Patrick, 76437 Rastatt (DE)
(86) Internationale Anmeldenummer: PCT/EP2018/056193
(87) Internationale Veröffentlichungsnummer: WO 2018/172137

(56) Entgegenhaltungen:
- US-A- 4 644 445
- US-A- 5 766 982
- US-A1- 2004 183 193
- US-A1- 2015 262 956

## Beschreibung

Die Erfindung betrifft eine Kontaktanordnung, umfassend einen Schaltungsträger, gemäß dem Oberbegriff des unabhängigen Anspruches.

### Stand der Technik

Zur Steigerung der Zuverlässigkeit elektronischer Baugruppen wird oft ein sogenannter Underfill verwendet. Dies entspricht einem Füllmaterial, welches in der Regel nach dem Bestücken eines elektronischen Bauelementes auf einem Schaltungsträger in einen vorliegenden Abstandsspalt zwischen dem elektronischen Bauelement und dem Schaltungsträger eingebracht wird und diesen vollständig ausfüllt. Im Consumer-Bereich kann dadurch beispielsweise einer Hauptbelastung durch überwiegend mechanischen Schock entgegengewirkt werden. Im Automobilbereich erfolgt eine Optimierung auf eine Temperaturwechsel-Belastung hin.

Gängige Underfill-Prozesse nutzen Kapillarkräfte, um den seitlich entlang der Bauelementkante dispensten Underfill unter das Bauelement zu saugen. Eine alternative Form des Unterfüllens ist das Material unter Druck durch ein Loch in der Leiterplatte zwischen außenliegenden Kontaktanschlüssen des elektronischen Bauelements zu applizieren, wie das beispielsweise in Ausführungen der Patentschrift US5766982 gezeigt ist. Dieses Verfahren hat diverse Vorteile, ist aber nur anwendbar, wenn es möglich ist, zwischen elektrisch kontaktierten Kontaktanschlüssen des elektronischen Bauelements eine Zugangsöffnung für den Underfill, beispielsweise durch Bohren, auszubilden.

Besonders elektronische Bauelemente, beispielsweise ein BGA-Bauelement (ball grid array), mit sehr kleinem Mitten-Mitten-Abstand der Kontaktanschlüsse (Pitch) benötigen oft einen Underfill. Leider ist es gerade bei diesen Bauelementen oft nicht möglich, aufgrund eines sehr kleinen Pitches, Öffnungen zwischen den angeordneten Kontaktanschlüssen vorzusehen. Dadurch ist die Zuverlässigkeit des elektronischen Bauelements gefährdet.

Aus der Offenlegungsschrift US2009/0229513 ist eine Kontaktanordnung, umfassend einen Schaltungsträger und ein mit dem Schaltungsträger kontaktiertes elektronisches Bauelement, bekannt. Hierbei wird eine Öffnung in dem Schaltungsträger unterhalb des kontaktierten elektronischen Bauelements dazu genutzt, durch Ansetzen einer Unterdruckvorrichtung das Ansaugen eines Underfills in den Abstandsspalt zwischen dem Schaltungsträger und dem elektronischen Bauelement zu erleichtern und ein vollständiges Ausfüllen sicherzustellen. Die Öffnung ist dabei zwischen zwei jeweils im Randbereich des elektronischen Bauelementes angeordneten Reihen mit Kontaktanschlüssen ausgebildet.

Die Patentschrift US4644445 zeigt eine artähnliche Kontaktanordnung, wobei allerdings Leiterbahnstrukturen des Schaltungsträgers über eine Öffnung im Schaltungsträger geführt sind zur elektrischen Kontaktierung von Kontaktanschlüssen eines elektronischen Bauelements. Ein Underfill kann seitlich an dem die Öffnung überbrückenden Teilabschnitt der Leiterbahnstruktur vorbei in den Abstandsspalt eingebracht werden. Das Einbringen des Underfills birgt jedoch die Gefahr, die Leiterbahnstruktur zu beschädigen und dadurch die eigentliche elektrische Funktion schädlich zu unterbinden.

Die Offenlegungsschrift US2015/0262956 A zeigt eine Kontaktanordnung zwischen einen Halbleiterbauelement und einem Substratträger, wobei der Substratträger in einem Verbindungbereich mit dem Halbleiterbauelement eine durchgehende Öffnung über den Substratdickenquerschnitt hinweg aufweist.

### Offenbarung der Erfindung

### Vorteile

Der Erfindung liegt die Aufgabe zu Grunde, das Einbringen eines Underfills bzw. eines Füllmaterials in einen Abstandsspalt zwischen einem Schaltungsträger und einem mit dem Schaltungsträger elektrisch kontaktierten elektronischen Bauelement sicherzustellen, insbesondere bei elektronischen Bauelementen mit einem kleinen Pitchabstandsmaß.

Diese Aufgabe wird durch eine Kontaktanordnung mit den kennzeichnenden Merkmalen des unabhängigen Anspruches gelöst.

Ausgegangen wird von einer Kontaktanordnung, umfassend einen Schaltungsträger mit einer Ober- und einer Unterseite und zumindest ein elektronisches Bauelement, wobei der Schaltungsträger zumindest Kontaktstellen auf der Oberseite aufweist, die mit Kontaktanschlüssen des elektronischen Bauelements elektrisch kontaktiert sind. Zusätzlich umfasst es ein Füllmaterial, welches einen Abstandsspalt zwischen der Oberseite des Schaltungsträgers und dem elektronischen Bauelement ausfüllt, wobei der Schaltungsträger eine Zugangsöffnung zum Einbringen des Füllmaterials aufweist. Hierbei kann das Füllmaterial von der Unterseite des Schaltungsträgers her beispielsweise unter Druck eingespritzt werden oder mittels Unterdruck von der Oberseite des Schaltungsträgers angesaugt werden. Das elektronische Bauelement weist auf einer der Oberseite des Schaltungsträgers zugewandten Bauelementenseite eine Musteranordnung der Kontaktanschlüssen auf, wobei eine Anschlussfläche von genau einem von drei nächst benachbarten Kontaktanschlüssen in einer senkrechten Projektion auf die Oberseite von der Zugangsöffnung zumindest teilweise überdeckt ist. Ferner ist der zur überdeckten Anschlussfläche zugehörige Kontaktanschluss frei von einer elektrischen Kontaktierung. In vorteilhafter Weise ergibt sich dadurch die Möglichkeit, das Füllmaterial durch die Zugangsöffnung an dem zugehörigen Kontaktanschluss vorbeizuführen und ein Befüllen des genannten Abstandsspaltes zu ermöglichen. Trotz einer Nähe des Kontaktanschlusses zur Zugangsöffnung und einer dadurch vorliegenden Art von Beschattung bzw. mechanischen Hürde, ist ein Durchfluss des Füllmaterials kaum behindert, insbesondere, wenn zwischen dem zugehörigen Kontaktanschluss und der Öffnung und/oder dem Schaltungsträger ein Spaltabstand verbleibt. Bevorzugt ist der als frei von einer elektrischen Kontaktierung vorliegende Anschlusskontakt gewählt aus einer Gruppe von redundanten Kontaktanschlüssen des elektronischen Bauelements, insbesondere ein Masseanschluss oder ein Spannungsversorgungsanschluss. Auf diese Weise sind die elektrischen Funktionen des elektronischen Bauelements weiterhin voll nutzbar. Zusätzlich ist eine elektrische Funktion des gesamten elektronischen Bauelements durch eine rein mechanische Beschädigung des genannten zugehörigen Kontaktanschlusses nicht gefährdet. Insgesamt ist auch der Einsatz von elektronischen Bauelementen nun vorteilhaft ermöglicht, die sehr nah zueinander liegende Kontaktanschlüsse aufweisen und welche bisher von einem sicheren Einbringen eines Füllmaterials in bereits beschriebener Weise ausgeschlossen waren. Falls erforderlich, können auch Anschlussflächen von mehr als einem der nächst benachbarten Kontaktanschlüssen in gleicher Weise zumindest teilweise überdeckt sein. Allerdings reduziert sich dadurch die Anzahl verbleibender elektrisch kontaktierbarer Kontaktanschlüsse, so dass bevorzugt ausschließlich nur ein Kontaktanschluss in beschriebener Weise für eine Zugangsöffnung geopfert wird.

Eine besonders günstige Ausführungsform der Kontaktanordnung ergibt sich, wenn die überdeckte Anschlussfläche in der Projektion vollständig innerhalb der Zugangsöffnung angeordnet ist. In einem gedachten Seitenschnitt durch die Zugangsöffnung hindurch steht der Anschlusskontakt von der Oberseite her bevorzugt zentriert oberhalb der Zugangsöffnung, wobei allseitig in Bezug zur Zugangsöffnung ein im Wesentlichen gleicher Spalt verbleibt. Auf diese Weise ist ein sehr gleichmäßiger und symmetrischer Fluss des Füllmaterials zwischen der Oberseite und der Bauelementenseite des elektronischen Bauelements ermöglicht, so dass ein Füllvermögen sehr begünstigt ist.

Bevorzugt ist eine Ausführungsform der Kontaktanordnung, bei welcher die drei nächst benachbarten Kontaktanschlüsse in einer Linie angeordnet sind und der zur überdeckten Anschlussfläche zugehörige Kontaktanschluss den mittleren Kontaktanschluss bildet. Demnach sind die äußeren beiden Kontaktanschlüsse elektrisch mit Kontaktstellen des Schaltungsträgers kontaktiert und der mittlere Kontaktanschluss zum Ermöglichen eines Einbringens des Füllmaterials unter Wegfall von dessen elektrischer Funktion geopfert. Die bisherige Forderung eines ausreichenden Abstandes von zwei unmittelbar benachbarten Kontaktanschlüssen in Bezug auf eine Größe einer vorzusehenden Zugangsöffnung kann damit vorteilhaft auf den Abstand der äußeren beiden Kontaktanschlüsse in der Linienreihe erweitert werden.

In einer Weiterbildung der Kontaktanordnung ist die Musteranordnung der Kontaktanschlüsse gebildet als eine Anordnung der Kontaktanschlüsse in einem Raster von parallelen Zeilen und parallelen Spalten. Bevorzugt sind die Zeilen- und/oder Spaltenabstände zueinander gleichbleibend, weiter bevorzugt entsprechen sich die Zeilen- und Spaltenabstände. Die Musteranordnung ist insbesondere derart ausgebildet, dass sich die Zeilen und Spalten senkrecht schneiden und die Kontaktanschlüsse in den jeweiligen Schnittpunkten angeordnet sind. Gleiches gilt für eine Ausführung, bei welcher sich die Zeilen und Spalten in einem von 90° abweichenden Winkel kreuzen, wodurch eine Anordnung beispielsweise in Form eines Wabengitters vorliegt. Je nach Anschlussschema eines elektronischen Bauelements sind Ausführungen denkbar, bei welchen in einzelnen der oben genannten Schnittpunkte kein elektrischer Kontaktanschluss ausgebildet ist, bevorzugt nur eine Minderheit davon. Insgesamt lassen sich auf diese Weise eine Vielzahl von Standardbauelementen einsetzen oder elektronische Bauelemente, die ein an die Standardbauelemente angelehntes Anschlussschema aufweisen.

Ein besonderer Vorteil zeigt sich in einer Ausführungsform der Kontaktanordnung, bei welcher der zur überdeckten Anschlussfläche zugehörige Kontaktanschluss zu zumindest einem der nächst benachbarten Kontaktanschlüsse einen Pitchabstand von <= 2 mm, insbesondere <= 0,65 mm, aufweist. Bevorzugt liegt ein solcher Pitchabstand zu beiden nächst benachbarten Kontaktanschlüssen vor. Der Pitchabstand zeigt sich dabei in einem Mitten-Mitten-Abstand zweier nächstbenachbarter Kontaktanschlüssen. Zur Bestimmung werden Symmetriepunkte oder -achsen der jeweiligen Kontaktschlüsse herangezogen und deren geringste Beabstandung zueinander bestimmt. Eine sehr einfache Bestimmung ergibt sich dabei bei einer insgesamt symmetrischen Musteranordnung der Kontaktanschlüsse. Sogenannte Pitchangaben sind in der Elektronikfertigung allgemein bekannt.

Bevorzugt weisen alle Kontaktanschlüsse der Musteranordnung einen jeweils gleichen Pitchabstand zueinander auf.

Insgesamt bevorzugt ist die Kontaktanordnung derart ausgebildet, dass die Zugangsöffnung eine maximale lichte Weite von <= 2,0, insbesondere <= 0,7 mm, aufweist. Die lichte Weite kennzeichnet demnach ein größtes Öffnungsmaß der Zugangsöffnung. Bevorzugt ergibt sich die maximale lichte Weite zwischen zweien Randpunkten der Zugangsöffnung, von den zumindest ein Randpunkt, bevorzugt beide, eine kürzeste Entfernung zu einem jeweils nächst angeordneten elektrisch kontaktierten Kontaktanschluss aufweist. In einfachster Ausführung ist die Zugangsöffnung zylindrisch ausgeformt mit dann einem Öffnungsdurchmesser von <= 2,0, insbesondere <= 0,7 mm. Dadurch kann insbesondere unter Druck, beispielsweise durch ein Einspritzen, das Füllmaterial in den Abstandsspalt zwischen dem elektronischen Bauelement und dem Schaltungsträger eingebracht werden. Bevorzugt weist der Öffnungsdurchmesser mindestens das doppelte Maß des Abstandsspaltes auf, wodurch auch ein Einziehen des Füllmaterials aufgrund von wirkenden Kapillarkräften erfolgen kann.

In Weiterbildung der Kontaktanordnung weist die die Musteranordnung der Kontaktanschlüsse aufweisende Bauelementenseite in der Projektion einen Flächenschwerpunkt in der projizierten Fläche auf, wobei zumindest eine im Schaltungsträger ausgebildete Zugangsöffnung im Bereich des Flächenschwerpunktes angeordnet ist. Die projizierte Fläche zeigt sich bevorzugt als kreisrunde Fläche. Ebenso sind quadratische oder rechteckige, ovale, rautenförmige oder allgemein symmetrische mehreckige Flächenformen denkbar, beispielsweise ein Fünfeck, Sechseck und weitere. Der Flächenschwerpunkt lässt sich nach bekannten geometrischen Regeln bestimmen. In der Regel entspricht die projizierte Fläche einer entsprechend ebenen Bauelementenseite. Eine solche ausgebildete Zugangsöffnung ist demnach in einem zentralen Bereich unterhalb der die Musteranordnung der Kontaktanschlüsse aufweisenden Bauelementenseite angeordnet. Ein Einbringen des Füllmaterials durch eine derartig angeordnete Zugangsöffnung ermöglicht eine gleichmäßige und symmetrische Befüllung des Abstandsspaltes zu allen Bauelementenrändern hin. Auf diese Weise ist auch sichergestellt, dass das Auffüllen ohne Verbleib von eingeschlossenen Luftblasen erfolgt. Alternativ oder zusätzlich sind zwei oder mehr Zugangsöffnungen punkt- und/oder rotationssymmetrisch um den Flächenschwerpunkt angeordnet. In dieser Form erfolgt ein Befüllen des Abstandsspaltes zeitgleich von mehreren Stellen aus, wodurch in einer Serienfertigung kleine Taktzeiten eingehalten werden können. In einer besonders vorteilhaften Ausführung sind die punkt- und/oder rotationssymmetrisch angeordneten zwei oder mehr Zugangsöffnungen derart zueinander angeordnet, dass um deren jeweilige Öffnungsachse gleich große konzentrische Kreise sich jeweils in einem Punkt berühren, wobei eine Summe der gebildeten Kreisflächen min. 60% und max. 140% der projizierten Fläche der Bauelementenseite entsprechen. Auf diese Weise ist ein solcher jeweiliger Abstand der Zugangsöffnung zueinander und zu dem Flächenschwerpunkt eingestellt, dass eine jeweilige konzentrisch um eine Zugangsöffnung sich ausbreitende Fließfront des Füllungsmaterials zeitgleich eine jeweilige äußere Bauelementenkante erreicht und der vollständige Abstandspalt zwischen dem elektronischen Bauelement und dem Schaltungsträger in jedem Bereich ausgefüllt ist. Das Befüllen kann somit in kürzest möglicher Zeit erfolgen.

Allgemein sind zur Ausbildung aller beschriebenen Kontaktanordnungen elektronische Bauelemente vorteilhaft vorgesehen, welche als Gehäuseform eine Ausführungsart von BGA (ball grid array), von LGA (land grid array), von PGA (pin grid array) oder von WLP (wafer level packaging) aufweisen.
Beispielhafte Ausführungsarten für ein BGA-Bauelement sind:
FBGA (Fine Pitch Ball Grid Array), LBGA (Low Profile Ball Grid Array), TEPBGA (Thermally Enhanced Plastic Ball Grid Array), CBGA (Ceramic Ball Grid Array), OBGA (Organic Ball Grid Array), TFBGA (Thin Fine Pitch Ball Grid Array), PBGA (Plastic Ball Grid Array), MAP-BGA (Mold Array Process - Ball Grid Array), UCSP Micro ((µ) Chip Scale Package), µBGA (Micro-Ball Grid Array), LFBGA (Low Profile Fine Pitch Ball Grid Array), TBGA (Thin Ball Grid Array), SBGA (Super Ball Grid Array), UFBGA (Ultra Fine Ball Grid Array), FC-BGA (Flip Chip BGA). Denkbar sind noch weitere Ausführungsarten.

Beispielhafte Ausführungsarten für ein PGA-Bauelement sind:
OPGA (Organic Pin Grid Array), FCPGA (Flip-chip Pin Grid Array), PAC (Pin Array Cartridge), PGA (Pin grid array), CPGA (Ceramic Pin Grid Array). Auch hier sind andere Ausführungsarten denkbar.

### Kurze Beschreibung der Zeichnungen

Weitere Vorteile, Merkmale und Einzelheiten der Erfindung ergeben sich aus der nachfolgenden Beschreibung bevorzugter Ausführungsbeispiele sowie anhand der Zeichnung. Diese zeigt in:
- Fig. 1:: eine erste Ausführung einer Kontaktanordnung in einer seitlichen Schnittdarstellung,
- Fig. 2a:: die erste Ausführung aus Fig. 1 in einer Draufsicht auf die Oberseite eines umfassenden Schaltungsträgers mit darauf schematisch dargestellten Projektionsflächen eines elektrisch kontaktierten Bauelements,
- Fig. 2b:: schematische Darstellung von Projektionsflächen eines elektrisch kontaktierten Bauelementes bei einer zweiten Ausführung einer Kontaktanordnung,
- Fig. 2c:: schematische Darstellung von Projektionsflächen eines elektrisch kontaktierten Bauelementes bei einer dritten Ausführung einer Kontaktanordnung,
- Fig. 2d:: schematische Darstellung von Projektionsflächen eines elektrisch kontaktierten Bauelementes bei einer vierten Ausführung einer Kontaktanordnung.

### Ausführungsformen der Erfindung

In den Figuren sind funktional gleiche Bauelemente jeweils mit gleichen Bezugszeichen gekennzeichnet.

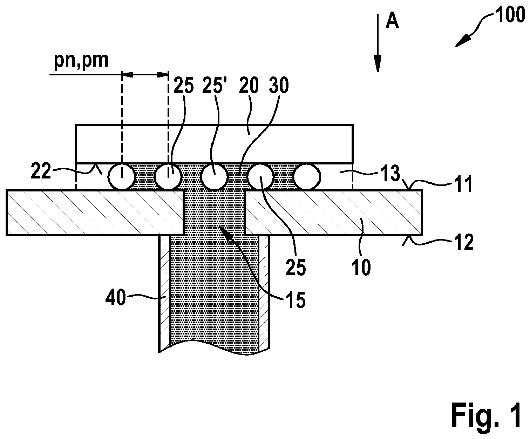

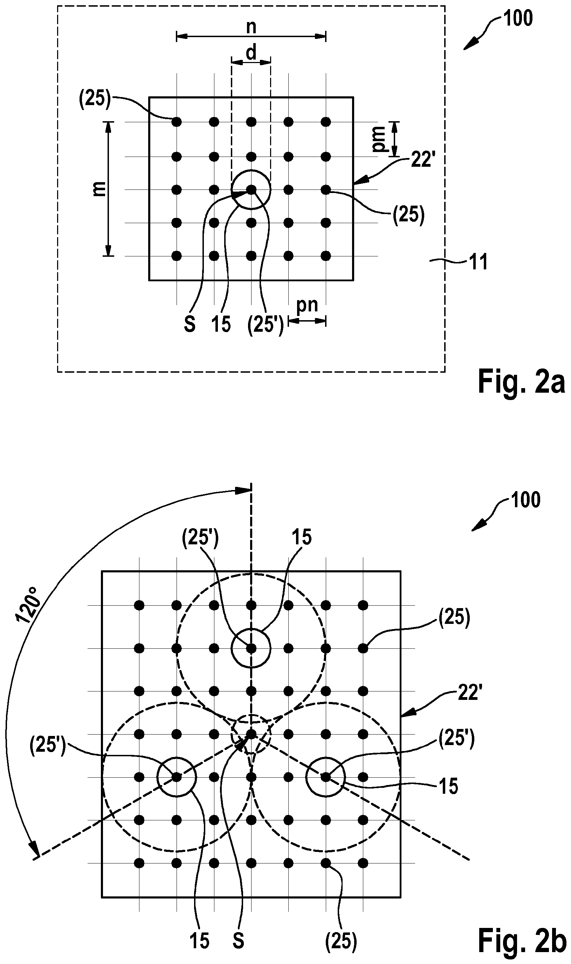

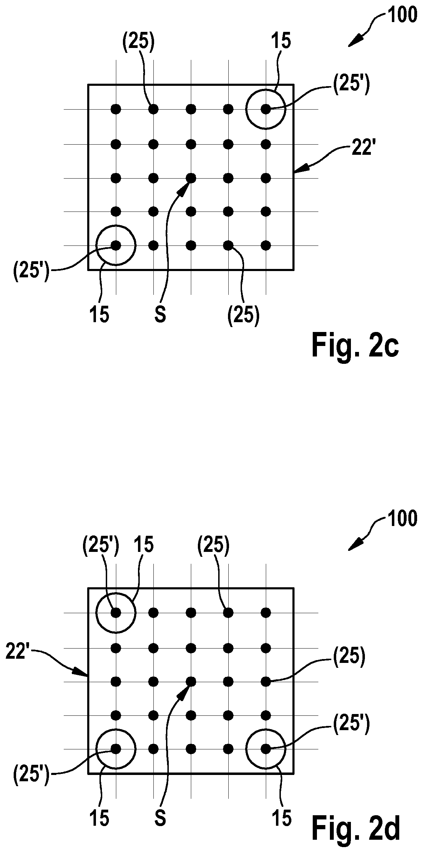

In der Fig. 1 ist eine erste Ausführung einer Kontaktanordnung 100 in einer seitlichen Schnittdarstellung gezeigt. Die Kontaktanordnung 100 umfasst hierbei zumindest einen Schaltungsträger 10, welcher eine Oberseite 11 und eine Unterseite 12 aufweist. Mit dem Schaltungsträger 10 ist zumindest ein elektrisches Bauelement 20 elektrisch kontaktiert. Die Oberseite 11 weist eine Vielzahl von Kontaktstellen auf (auch als Pads bezeichnet, nicht dargestellt), die mit komplementären Kontaktanschlüssen 25 des elektrischen Bauelements 20 elektrisch verbunden sind, beispielsweise mittels eines Lotmaterials. Die Kontaktanschlüsse 25 sind hierbei in einer Musteranordnung auf einer der Oberseite 11 zugewandten Bauteilelementenseite 22 angeordnet. In der Schnittdarstellung der Fig. 1 sind lediglich eine Anzahl von Kontaktanschlüssen 25 dargestellt, die in einer Linie angeordnet sind. Mögliche Musteranordnungen werden noch später mit Hilfe der Fig. 2a - 2d erläutert.

Der Schaltungsträger 10 weist eine Zugangsöffnung 15 auf, welche die Oberseite 11 und die Unterseite 12 durchdringt. Mittels der Zugangsöffnung 15 ist das Einbringen eines Füllmaterials 30 in einen zwischen dem elektronischen Bauelement 20 und dem Schaltungsträger 10 ausgebildeten Abstandsspalt 13 ermöglicht. Dies kann beispielhaft durch eine Füllvorrichtung 40 erfolgen, welche das Füllmaterial 30 mit Druck durch die Zugangsöffnung 15 einspritzt. Mit zunehmenden Füllgrad ist der Abstandsspalt 13 dann bevorzugt bis zu den Bauelementenrändern vollständig mit dem Füllmaterial 30 ausgefüllt (gestrichelt dargestellt). Die Zugangsöffnung 15 ist derart in dem Schaltungsträger 10 und in Bezug zu der Musteranordnung an Kontaktanschlüssen 25 angeordnet, dass zumindest ein Kontaktanschluss 25' zumindest teilweise oberhalb der Zugangsöffnung 15 freistehend, insbesondere zu dieser zentriert, angeordnet ist und dadurch frei von jeglicher elektrischer Kontaktierung ist. Die Anordnung der Zugangsöffnung ist weiter verdeutlicht in der Fig. 2a gezeigt. Diese zeigt in einer senkrechten Sicht A auf die Oberseite 11 des Schaltungsträgers 10 lediglich die Projektionsfläche 22' der oben bezeichneten Bauelementenseite 22 und die sich aus einer Musteranordnung ergebenden Projektionsflächen der angeordneten Kontaktanschlüsse 25. Vereinfacht ist noch gestrichelt eine Berandung des Schaltungsträgers 10 gezeigt. Die Musteranordnung der Kontaktanschlüsse 25 ist beispielsweise gebildet als eine Anordnung der Kontaktanschlüsse 25 in einem Raster von parallelen Zeilen und parallelen Spalten, insbesondere in Form einer n x m-Matrix, wobei durch n beispielsweise die Anzahl an Spalten und durch m die Anzahl der Zeilen bezeichnet sind. Die Anzahl der Spalten n und/oder der Zeilen m ist jeweils beispielsweise >=3, bevorzugt >= 20, wie beispielsweise zwischen 20 und 60, insbesondere bis 100. Zur Verdeutlichung sind Rasterlinien dargestellt, wobei die Kontaktanschlüsse 25 bevorzugt in allen Schnittpunkten der Rasterlinien ausgebildet sind. Eine Musteranordnung kann alternativ auch in anderen Formen ausgebildet sein. Insgesamt weisen die in einer Spalte n in Linie angeordneten Kontaktanschlüsse 25 einen Pitchabstand pm auf und die in einer Zeile m angeordneten Kontaktanschlüsse 25 einen Pitchabstand pn auf. Die Pitchabstände pm und pn sind bevorzugt lediglich <= 2 mm groß, insbesondere <= 0,65 mm. In der Fig. 2a ist auch die Berandung der Zugangsöffnung 15 ersichtlich, welche beispielsweise eine kreisrunde Fläche umschließt aufgrund einer zylindrischen Ausbildung der Zugangsöffnung 15. Es zeigt sich, dass in der Projektion in einer Gruppe von benachbarten Kontaktanschlüssen 25 die Anschlussfläche zumindest eines von drei nächst benachbarten Kontaktanschlüssen 25 innerhalb der Berandung der Zugangsöffnung 15 angeordnet ist. Demnach ist die betreffende Anschlussfläche des einen Kontaktanschlusses 25' in der Projektion vollständig von der Fläche der Zugangsöffnung 15 überdeckt. Alternativ kann auch nur eine teilweise Überdeckung vorliegen und/oder die Anschlussflächen von mehreren Kontaktanschlüssen 25' derartig vollständig oder teilweise überdeckt sein. Die Zugangsöffnung weist eine maximale lichte Weite d von >=2 mm, insbesondere von >=0,7 mm auf. Ferner ist die Zugangsöffnung 15 bevorzugt in oder zumindest in einem unmittelbaren Bereich des Flächenschwerpunktes S der Projektionsfläche 22' der Bauelementenseite 22 angeordnet. Auf diese Weise ergibt sich ein sehr zentraler Zugang des Füllmaterials 30 zum Befüllen des Abstandsspaltes 13.

Aus den Fig. 2b - 2d gehen weitere mögliche Ausführungen einer Kontaktanordnung 100 hervor. Im Wesentlichen entsprechen diese der ersten Ausführung gemäß den Fig. 1 und 2a. Die Unterschiede zeigen sich lediglich wie nachfolgend aufgeführt (die Berandung des Schaltungsträger 10 ist zur Vereinfach nicht weiter abgebildet).

Die zweite Ausführung der Kontaktanordnung gemäß der Fig. 2b weist insgesamt 3 Zugangsöffnungen 15 in dem Schaltungsträger 10 auf. Diese sind rotationssymmetrisch um den Flächenschwerpunkt S in 120° Winkelabständen zueinander angeordnet. Bevorzugt sind diese Zugangsöffnungen 15 in einem jeweiligen Abstand zu dem Flächenschwerpunkt S derart angeordnet, dass um deren jeweilige Öffnungsachse gleich große konzentrische Kreise sich jeweils in einem Punkt berühren (gestrichelt dargestellt), wobei eine Summe der gebildeten Kreisflächen min. 60% und max. 140% der projizierten Fläche 22' der Bauelementenseite 22 entsprechen. Zusätzlich kann auch eine vierte Zugangsöffnung wie bei der ersten Ausführung im Schwerpunkt S angeordnet sein (gestrichelt gezeichnet). Nur rein beispielhaft ist im Gegensatz zur Ausführung zur Fig. 2a eine größere Anzahl an Kontaktanschlüssen 25 gezeigt.

Die dritte Ausführung der Kontaktanordnung ist in Fig. 2c gezeigt. Diese zeigt im Gegensatz zu den vorhergehenden Ausführungsformen insgesamt zwei Zugangsöffnungen 15, die diagonal gegenüberliegend in Ausrichtung zu den Ecken der Projektionsfläche 22' der Bauelementenseite 22 angeordnet sind, insbesondere punkt- und/oder rotationssymmetrisch zum Flächenschwerpunkt S.

In der vierten Ausführung der Kontaktanordnung 100 sind insgesamt drei Zugangsöffnungen 15 in Ausrichtung zu den Ecken der Projektionsfläche 22' der Bauelementenseite 22 angeordnet, teilähnlich wie bei der dritten Ausführung.

Grundsätzlich sind die gleiche Anzahl an Zugangsöffnungen 15 oder weitere in anderer Anordnung im Schaltungsträger 10 denkbar. Ebenso kann ein elektrisches Bauelement 20 alternativ oder zusätzlich auf der Unterseite 12 des Schaltungsträgers 10 elektrisch kontaktiert angeordnet sein. Bevorzugt weisen die kontaktierten Bauelemente 20 verschiedenster Ausführungen der Kontaktanordnung 100 eine Gehäuseform gemäß einer Ausführungsart von BGA (ball grid array), von LGA (land grid array), von PGA (pin grid array) oder von WLP (wafer level packaging) auf. In der Schnittdarstellung der Fig. 1 sind beispielsweise Kontaktanschlüsse 25 eines BGA-Bauelementes gezeigt. Im Bereich der gezeigten Zugangsöffnung 15 verbleibt ein Abstandspalt zum elektrisch freiliegenden Ball 25', so dass ein Füllmaterial daran vorbeigeführt in den Abstandsspalt 13 gelangt.

## Patentansprüche

1. Kontaktanordnung (100), umfassend einen Schaltungsträger (10) mit einer Ober- und einer Unterseite (11, 12) und zumindest ein elektronisches Bauelement (20), wobei der Schaltungsträger (10) zumindest Kontaktstellen auf der Oberseite (11) aufweist, die mit Kontaktanschlüssen (25) des elektronischen Bauelements (20) elektrisch kontaktiert sind, und einem Füllmaterial (30), welches einen Abstandsspalt (13) zwischen der Oberseite (11) des Schaltungsträgers (10) und dem elektronischen Bauelement (20) ausfüllt, wobei der Schaltungsträger (10) eine Zugangsöffnung (15) zum Einbringen des Füllmaterials (30) aufweist, wobei das elektronische Bauelement (20) auf einer der Oberseite (11) des Schaltungsträgers (20) zugewandten Bauelementenseite (22) eine Musteranordnung der Kontaktanschlüssen (25) aufweist,
**dadurch gekennzeichnet, dass**
eine Anschlussfläche von zumindest einem von drei nächst benachbarten Kontaktanschlüssen (25, 25') in einer senkrechten Projektion auf die Oberseite (11) von der Zugangsöffnung (15) zumindest teilweise überdeckt ist und der zur überdeckten Anschlussfläche zugehörige Kontaktanschluss (25') frei von einer elektrischen Kontaktierung ist.

2. Kontaktanordnung (100) nach Anspruch 1,
**dadurch gekennzeichnet, dass**
die überdeckte Anschlussfläche in der Projektion vollständig innerhalb der Zugangsöffnung (15) angeordnet ist.

3. Kontaktanordnung (100) nach Anspruch 1 oder 2,
**dadurch gekennzeichnet, dass**
die drei nächst benachbarten Kontaktanschlüsse (25, 25') in einer Linie angeordnet sind und der zur überdeckten Anschlussfläche zugehörige Kontaktanschluss (25') den mittleren Kontaktanschluss bildet.

4. Kontaktanordnung (100) nach einem der vorhergehenden Ansprüche,
**dadurch gekennzeichnet, dass**
die Musteranordnung der Kontaktanschlüsse (25, 25') gebildet ist als eine Anordnung der Kontaktanschlüsse in einem Raster von parallelen Zeilen und parallelen Spalten.

5. Kontaktanordnung (100) nach einem der vorhergehenden Ansprüche,
**dadurch gekennzeichnet, dass**
der zur überdeckten Anschlussfläche zugehörige Kontaktanschluss (25') zu zumindest einem der nächst benachbarten Kontaktanschlüsse (25), bevorzugt zu beiden nächst benachbarten Kontaktanschlüssen (25), einen Pitchabstand von <= 2 mm, insbesondere <= 0,65 mm, aufweist.

6. Kontaktanordnung (100) nach einem der vorhergehenden Ansprüche,
**dadurch gekennzeichnet, dass**
alle Kontaktanschlüsse (25, 25') der Musteranordnung, einen jeweils gleichen Pitchabstand zueinander aufweisen.

7. Kontaktanordnung (100) nach einem der vorhergehenden Ansprüche,
**dadurch gekennzeichnet, dass**
die Zugangsöffnung (15) eine maximale lichte Weite (d) von <= 2,0, insbesondere <= 0,7 mm, aufweist und/oder die Zugangsöffnung zylindrisch ist und einen Öffnungsdurchmesser (d) von <= 2,0, insbesondere <= 0,7 mm, oder mindestens das doppeltem Maß des Abstandsspaltes (13), aufweist.

8. Kontaktanordnung (100) nach einem der vorhergehenden Ansprüche,
**dadurch gekennzeichnet, dass**
die die Musteranordnung der Kontaktanschlüsse (25, 25') aufweisende Bauelementenseite (22) in der Projektion einen Flächenschwerpunkt (S) in der projizierten Fläche (22') aufweist und zumindest eine Zugangsöffnung (15) im Bereich des Flächenschwerpunktes (S) angeordnet ist und/oder zwei oder mehr Zugangsöffnungen (15) punkt- und/oder rotationssymmetrisch um den Flächenschwerpunkt (S) angeordnet sind.

9. Kontaktanordnung (100) nach Anspruch 8,
**dadurch gekennzeichnet, dass**
die punkt- und/oder rotationssymmetrisch angeordneten zwei oder mehr Zugangsöffnungen (15) derart zueinander angeordnet sind, dass um deren jeweilige Öffnungsachse gleich große konzentrische Kreise sich jeweils in einem Punkt berühren, wobei eine Summe der gebildeten Kreisflächen min. 60% und max. 140% der projizierten Fläche (22') der Bauelementenseite entsprechen.

10. Kontaktanordnung (100) nach einem der vorhergehenden Ansprüche,
**dadurch gekennzeichnet, dass**
das elektronische Bauelement (20) als Gehäuseform eine Ausführungsart von BGA (ball grid array), von LGA (land grid array), von PGA (pin grid array) oder von WLP (wafer level packaging) aufweist.

## Claims

1. Contact arrangement (100), comprising a circuit carrier (10) with a top side (11) and a bottom side (12) and at least one electronic component (20), wherein the circuit carrier (10) has at least contact points on the top side (11), which contact points are electrically contacted by contact connections (25) of the electronic component (20), and a filling material (30) which fills a spacer gap (13) between the top side (11) of the circuit carrier (10) and the electronic component (20), wherein the circuit carrier (10) has an access opening (15) for introducing the filling material (30), wherein the electronic component (20) has a pattern arrangement of the contact connections (25) on a components side (22) which faces the top side (11) of the circuit carrier (20),
**characterized in that**
a connection area of at least one of three immediately adjacent contact connections (25, 25') is at least partially covered by the access opening (15) in a vertical projection onto the top side (11) and the contact connection (25') associated with the covered connection area is free of electrical contacting.

2. Contact arrangement (100) according to Claim 1,
**characterized in that**
the covered connection area is arranged completely within the access opening (15) in the projection.

3. Contact arrangement (100) according to Claim 1 or 2,
**characterized in that**
the three immediately adjacent contact connections (25, 25') are arranged in a row and the contact connection (25') associated with the covered connection area forms the middle contact connection.

4. Contact arrangement (100) according to one of the preceding claims,
**characterized in that**
the pattern arrangement of the contact connections (25, 25') is formed as an arrangement of the contact connections in a grid of parallel rows and parallel columns.

5. Contact arrangement (100) according to one of the preceding claims,
**characterized in that**
the contact connection (25') associated with the covered connection area has a pitch spacing of <= 2 mm, in particular <= 0.65 mm, from at least one of the immediately adjacent contact connections (25), preferably from both immediately adjacent contact connections (25).

6. Contact arrangement (100) according to one of the preceding claims,
**characterized in that**
all of the contact connections (25, 25') of the pattern arrangement have a respectively identical pitch spacing from one another.

7. Contact arrangement (100) according to one of the preceding claims,
**characterized in that**
the access opening (15) has a maximum clear width (d) of <= 2.0, in particular <= 0.7 mm, and/or the access opening is cylindrical and has an opening diameter (d) of <= 2.0, in particular <= 0.7 mm, or at least double the size of the spacer gap (13).

8. Contact arrangement (100) according to one of the preceding claims,
**characterized in that**
the components side (22) having the pattern arrangement of the contact connections (25, 25') has an area centre of gravity (S) in the projected area (22') in the projection and at least one access opening (15) is arranged in the region of the area centre of gravity (S) and/or two or more access openings (15) are arranged in a point-symmetrical and/or rotationally symmetrical manner about the area centre of gravity (S).

9. Contact arrangement (100) according to Claim 8,
**characterized in that**
the point-symmetrically and/or rotationally symmetrically arranged two or more access openings (15) are arranged in relation to one another in such a way that concentric circles of equal size each make contact at one point about the respective opening axis of said access openings, wherein a sum of the circle areas formed is a minimum of 60% and a maximum of 140% of the projected area (22') of the components side.

10. Contact arrangement (100) according to one of the preceding claims,
**characterized in that**
the electronic component (20) has, as a housing form, a BGA (ball grid array), LGA (land grid array), PGA (pin grid array) or WLP (wafer level packaging) type of design.

## Revendications

1. Arrangement de contact (100), comportant un porte-circuit (10) doté d'un côté supérieur et d'un côté inférieur (11, 12) et au moins un composant électronique (20), le porte-circuit (10) comprenant au moins des points de contact sur le côté supérieur (11), lesquels sont mis en contact électrique avec des bornes de contact (25) du composant électronique (20), et un matériau de remplissage (30), lequel remplit un interstice d'espacement (13) entre le côté supérieur (11) du porte-circuit (10) et le composant électronique (20), le porte-circuit (10) comprenant une ouverture d'accès (15) pour l'introduction du matériau de remplissage (30), le composant électronique (20) comprenant, sur un côté de composant (22) tourné vers le côté supérieur (11) du porte-circuit (20), un arrangement à motif des bornes de contact (25),
**caractérisé en ce**
**qu'**une surface de borne d'au moins une borne parmi trois bornes de contact (25, 25') immédiatement adjacentes est recouverte au moins partiellement par l'ouverture d'accès (15) dans une projection verticale sur le côté supérieur (11) et la borne de contact (25') associée à la surface de borne recouverte est exempte d'une mise en contact électrique.

2. Arrangement de contact (100) selon la revendication 1,
**caractérisé en ce que**
la surface de borne recouverte est disposée complètement à l'intérieur de l'ouverture d'accès (15) dans la projection.

3. Arrangement de contact (100) selon la revendication 1 ou 2,
**caractérisé en ce que**
les trois bornes de contact (25, 25') immédiatement adjacentes sont disposées en une ligne et la borne de contact (25') associée à la surface de borne recouverte forme la borne de contact centrale.

4. Arrangement de contact (100) selon l'une des revendications précédentes,
**caractérisé en ce que**
l'arrangement à motif des bornes de contact (25, 25') est formé comme un arrangement des bornes de contact dans une grille de lignes parallèles et de colonnes parallèles.

5. Arrangement de contact (100) selon l'une des revendications précédentes,
**caractérisé en ce que**
la borne de contact (25') associée à la surface de borne recouverte présente, par rapport à au moins l'une des bornes de contact (25) immédiatement adjacentes, de préférence par rapport aux deux bornes de contact (25) immédiatement adjacentes, une distance de pas <= 2 mm, en particulier <= 0,65 mm.

6. Arrangement de contact (100) selon l'une des revendications précédentes,
**caractérisé en ce que**
toutes les bornes de contact (25, 25') de l'arrangement à motif présentent une distance de pas respectivement identique les unes par rapport aux autres.

7. Arrangement de contact (100) selon l'une des revendications précédentes,
**caractérisé en ce que**
l'ouverture d'accès (15) présente une largeur intérieure maximale (d) <= 2,0, en particulier <= 0,7 mm, et/ou l'ouverture d'accès est cylindrique et présente un diamètre d'ouverture (d) <= 2,0, en particulier <= 0,7 mm, ou d'au moins le double de la dimension de l'interstice d'espacement (13).

8. Arrangement de contact (100) selon l'une des revendications précédentes,
**caractérisé en ce que**
le côté de composant (22) comprenant l'arrangement à motif des bornes de contact (25, 25') présente, dans la projection, un barycentre de surface (S) dans la surface projetée (22') et au moins une ouverture d'accès (15) est disposée dans la région du barycentre de surface (S) et/ou deux ou plus de deux ouvertures d'accès (15) sont disposées de manière à présenter une symétrie ponctuelle et/ou de révolution autour du barycentre de surface (S).

9. Arrangement de contact (100) selon la revendication 8,
**caractérisé en ce que**
les deux ou plus de deux ouvertures d'accès (15) disposées de manière à présenter une symétrie ponctuelle et/ou de révolution sont disposées les unes par rapport aux autres de telle sorte que des cercles concentriques de même dimension autour de leurs axes d'ouverture respectifs sont en contact respectivement en un point, une somme des surfaces circulaires formées correspondant au minimum à 60% et au maximum à 140% de la surface projetée (22') du côté de composant.

10. Arrangement de contact (100) selon l'une des revendications précédentes,
**caractérisé en ce que**
le composant électronique (20) présente comme forme de boîtier un mode de réalisation de type BGA (ball grid array, boîtier matriciel à billes), LGA (land grid array, boîtier matriciel à plots), PGA (pin grid array, boîtier matriciel à broches) ou WLP (wafer level packaging, encapsulation sur tranche).
